(19) Europäisches Patentamt

European Patent Office

Office européen des brevets

(11) **EP 3 554 201 B1**

(12) **EUROPEAN PATENT SPECIFICATION**

(45) Date of publication and mention
of the grant of the patent:
**17.05.2023 Bulletin 2023/20**

(21) Application number: **18166861.7**

(22) Date of filing: **11.04.2018**

(51) International Patent Classification (IPC):
**H05K 3/30** *(2006.01)*

(52) Cooperative Patent Classification (CPC):
**H05K 3/308; H05K 13/0421;** H05K 2201/10757;
H05K 2203/0195

(54) **METHOD AND DEVICE FOR PROCESSING A RADIAL ELECTRONIC COMPONENT**

VERFAHREN UND VORRICHTUNG ZUR BEARBEITUNG EINES RADIALEN ELEKTRONISCHEN
BAUTEILS

PROCÉDÉ ET DISPOSITIF DE TRAITEMENT D'UN COMPOSANT ÉLECTRONIQUE RADIAL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**16.10.2019 Bulletin 2019/42**

(73) Proprietor: **Salcomp Oyj**
**24101 Salo (FI)**

(72) Inventors:
• **VALJUS, Simo**
**08200 Lohja (FI)**
• **SAVOLAINEN, Kari**
**03220 Tervalampi (FI)**
• **KUOSMANEN, Pertti**
**08350 Lohja (FI)**
• **HÄRKÄLÄ, Pekka**
**08350 Lohja (FI)**
• **KANTOLA, Juha**
**08700 Lohja (FI)**
• **MÄKELÄ, Vesa**
**08200 Lohja (FI)**
• **NUMMENPÄÄ, Pekka**
**24260 Salo (FI)**

(74) Representative: **Berggren Oy**
**P.O. Box 16**
**Eteläinen Rautatiekatu 10A**
**00101 Helsinki (FI)**

(56) References cited:
**GB-A- 895 321**     **GB-A- 2 069 382**
**US-A- 3 783 488**     **US-A1- 2003 038 160**
**US-A1- 2013 025 923**

## Description

TECHNICAL FIELD OF THE INVENTION

The present invention relates to a method for processing a radial electronic component according to the appended claims.

BACKGROUND OF THE INVENTION

Various techniques for mounting electronic components on a circuit board are known in the prior art. One of these techniques is a through-hole mounting technique that can be used for mounting radial electronic components. In the through-hole mounting, leads of a radial electronic component are inserted into holes in a circuit board and the ends of the leads that extend through to the surface of the circuit board remote from the component body are soldered to a circuit pattern on that surface.

A problem associated with the known through-hole mounting technique is that the ends of the leads must be bent (i.e. clinched) prior to soldering to keep the radial electronic component in place in the circuit board. Without bending the leads, the radial electronic component is likely to fall out from the circuit board. Another problem associated with the known through-hole mounting technique is that insertion of the leads into the holes in the circuit board can be difficult because, due to the manufacturing tolerances of the radial electronic components, the pitch of the leads is rarely the same as the pitch of the holes. In some component mounting devices radial electronic components having a wrong pitch are discarded, which makes these devices unsatisfactory both from a cost and an ecological point of view. In some component mounting devices the pitch problem has been tried to solve by using a visual system to check the pitch of the leads and then by correcting the pitch with a pitch calibration system if needed before insertion. This is, however, a slow and complicated process, which remarkably slows down the mounting speed of electronic components.

US2013025923 describes a method for fixing a radial component on a circuit board before making an electrical connection by soldering. The wire terminals of the component are bent for producing a friction between the edges of the through hole into which the wires are inserted. US2003038160 describes a method for mounting a radial ceramic electronic component that can prevent cracking and detachment of terminal electrodes due to the contractive stresses in the solder.

OBJECTIVES OF THE INVENTION

It is the main objective of the present invention to reduce or even eliminate the prior art problems presented above.

It is an objective of the present invention to provide a method for processing a radial electronic component in such a manner that the radial electronic component is suitable to be mounted on a circuit board. In more detail, it is an objective of the invention to provide a method, which enables mounting of a radial electronic component on a circuit board without the need to bend ends of the leads of the radial electronic component after the leads have been inserted into holes in the circuit board. It is a further objective of the invention to provide a method, which removes the problem of the prior art related to the wrong pitch of leads of a radial electronic component.

In order to realise the above-mentioned objectives, the method according to the invention is characterised by what is presented in the characterising part of the appended independent claim. Advantageous embodiments of the invention are described in the dependent claims.

DESCRIPTION OF THE INVENTION

A method for processing a radial electronic component according to the invention comprises bending a first lead and/or a second lead of the radial electronic component so that the pitch of the leads, which means a distance between the centres of the ends of the leads, is different from the pitch of holes in a circuit board, into which holes the leads are to be inserted, cutting the first lead and the second lead obliquely, and inserting the first lead and the second lead into the holes in the circuit board.

The method according to the invention is meant to be used in a through-hole mounting scheme to process leads of a radial electronic component before the leads are inserted into holes in a circuit board. By a radial electronic component can be meant an electronic component having leads that project essentially in parallel (side by side) from the same end of a component body. When placed on a circuit board, this radial electronic component stands up essentially perpendicularly from the circuit board. In this text by a radial electronic component can also be meant an electronic component having leads protruding from opposite ends of a component body and wherein one of the leads has been bent into a U-shape so that it ends up close to and in parallel (side by side) with the other lead, or wherein both of the leads have been bent into an L-shape so that the end portions of the leads are essentially parallel with each other. Examples of a radial electronic component are a resistor, a capacitor and an inductor.

In the method according to the invention the first lead and/or the second lead of the radial electronic component is bent so that the pitch of the leads is smaller or larger than the pitch of the holes in the circuit board. The leads of the radial electronic component can be bent in such a manner that only the first lead or only the second lead is bent, or that both the first lead and the second lead are bent. The bending of the lead(s) can be performed in many ways, provided that after bending the pitch of the leads differs from the pitch of the holes into which holes the leads are to be inserted. By the pitch of the leads is meant a distance between the centres of the ends of the leads. By the pitch of the holes is meant a distance between the centres of the holes.

In the method according to the invention the first lead and the second lead of the radial electronic component are cut obliquely. This means that the leads are cut at an angle with respect to the cross direction of the lead. In other words, the leads are cut in such a manner that the cutting surfaces of the leads are inclined. The leads of the radial electronic component may be cut before or after their bending. The leads of the radial electronic component are cut obliquely in such a manner that the cutting surfaces have opposite orientations. The leads are cut obliquely so that the cutting surfaces of the leads are towards or away from each other. Preferably, the leads are cut into the same length.

A radial electronic component that has been processed with the method according to the invention is mounted to a circuit board by placing the ends of the leads into the holes in the circuit board and by pressing the component body towards the circuit board. When the leads protrude into the holes in the circuit board, the leads are pressed against the edges of the holes because the pitches of the leads and the holes differ from each other. The edges of the holes bend the leads closer to or away from each other depending on whether the pitch of the leads is larger or smaller than the pitch of the holes. The bevelled ends of the leads facilitate the insertion of the leads into the holes.

An advantage of the method according to the invention is that a radial electronic component that has been processed with the method according to the invention can be mounted on a circuit board without the need to bend ends of the leads of the radial electronic component after the leads have been inserted into the holes in the circuit board. The friction between the leads and the edges of the holes keeps the radial electronic component in place in the circuit board before and during the soldering of the ends of the leads to the circuit board. The bevelled cutting of the leads facilitates the insertion of the leads into the holes in the circuit board.

According to an embodiment of the invention the first lead and/or the second lead is bent so that the pitch of the leads differs from the pitch of the holes by at least 0.1 mm. This difference has been found sufficient to keep the radial electronic component in place in the circuit board. To increase the holding force, the pitch of the leads may be arranged to differ from the pitch of the holes by at least 0.15 mm or by at least 0.3 mm.

According to an embodiment of the invention the first lead and the second lead are cut at an angle of 20 to 70 degrees with respective to the longitudinal axis of the lead. This range has been found preferable because it makes the insertion of the leads into the holes easy. The first lead and the second lead are preferably cut at an angle of 30 to 60 degrees and more preferably at an angle of 40 to 50 degrees with respective to the longitudinal axis of the lead. Preferably, the leads are cut at the same angle but in a way where the cutting surfaces of the leads have opposite orientations.

According to an embodiment of the invention the first lead and/or the second lead is bent so that the pitch of the leads is smaller than the pitch of the holes, and the first lead and the second lead are cut obliquely so that cutting surfaces of the leads are towards each other. That the cutting surfaces are towards each other means that the ends of the leads are bevelled inwardly, and they have opposite orientations. The mathematical relationship between the pitches of the leads and the holes and the diameters of the leads and the holes can be expressed by the following equation:

$$p_H - d_H - d_L < p_L < p_H,$$

wherein $p_H$ denotes the pitch of the holes, $p_L$ denotes the pitch of the leads, $d_H$ denotes the diameter of the hole and $d_L$ denotes the diameter of the lead.

According to an embodiment of the invention the step of bending a first lead and/or a second lead of the radial electronic component comprises arranging a spacer plate having opposite first and second sides between the first lead and the second lead and pushing the first lead against the first side and the second lead against the second side of the spacer plate. A first pushing arm can be used for pushing the first lead against the first side of the spacer plate, and a second pushing arm can be used for pushing the second lead against the second side of the spacer plate. The pitch of the leads after the radial electronic component has been processed is equal to the sum of the thickness of the spacer plate and the diameter of the lead. The spacer plate is preferably used in a case where the pitch of the leads is intended to be smaller than the pitch of the holes.

According to an embodiment of the invention the first lead and/or the second lead is bent so that the pitch of the leads is larger than the pitch of the holes, and the first lead and the second lead are cut obliquely so that the cutting surfaces of the leads are away from each other. That the cutting surfaces are away from each other means that the ends of the leads are bevelled outwardly, and they have opposite orientations. The mathematical relationship between the pitches of the leads and the holes and the diameters of the leads and the holes can be expressed by the following equation:

$$p_H < p_L < p_H + d_H + d_L,$$

wherein $p_H$ denotes the pitch of the holes, $p_L$ denotes the pitch of the leads, $d_H$ denotes the diameter of the hole and $d_L$ denotes the diameter of the lead.

According to an embodiment of the invention the step of bending a first lead and/or a second lead of the radial electronic component comprises arranging the first lead and the second lead in a space between a first spacer arm and a second spacer arm and pushing the first lead against the first spacer arm and the second lead against the second spacer arm. A third pushing arm can be used for pushing the first lead against the first spacer arm and a fourth pushing arm can be used for pushing the second lead against the second spacer arm. The pitch of the leads after the radial electronic component has been processed is equal to the subtraction of the distance between the first and second spacer arms and the diameter of the lead. The spacer arms are preferably used in a case where the pitch of the leads is intended to be larger than the pitch of the holes.

A device for processing a radial electronic component not forming a part of the invention and described here in order to facilitate better understanding of the invention comprises bending means for bending a first lead and/or a second lead of the radial electronic component so that the pitch of the leads is different from the pitch of holes in a circuit board, into which holes the leads are to be inserted, and cutting means for cutting the first lead and the second lead obliquely.

The device can be used in an electronic component mounting device to process leads of a radial electronic component before the radial electronic component is mounted on a circuit board. A radial electronic component that has been processed with the device can be mounted to a circuit board by placing the ends of the leads into the holes in the circuit board and by pressing the component body towards the circuit board. When the leads protrude into the holes in the circuit board, the leads are pressed against the edges of the holes because the pitches of the leads and the holes differ from each other. The edges of the holes bend the leads closer to or away from each other depending on whether the pitch of the leads is larger or smaller than the pitch of the holes. The bevelled ends of the leads facilitate the insertion of the leads into the holes.

The bending means are configured to bend the first lead and/or the second lead of the radial electronic component so that the pitch of the leads becomes smaller or larger than the pitch of the holes in the circuit board. The bending means can be arranged to bend the leads of the radial electronic component in such a manner that only the first lead or only the second lead is bent, or that both the first lead and the second lead are bent. The cutting means are used to cut the first lead and the second lead of the radial electronic component obliquely. The cutting means can be arranged to cut the leads before or after their bending with the bending means.

An advantage of the device is that a radial electronic component that has been processed with the device can be mounted on a circuit board without the need to bend ends of the leads of the radial electronic component after the leads have been inserted into the holes in the circuit board. The friction between the leads and the edges of the holes keeps the radial electronic component in place in the circuit board before and during the soldering of the leads to the circuit board. The bevelled cutting of the leads facilitates the insertion of the leads into the holes in the circuit board.

The bending means of the device may be configured to bend the first lead and/or the second lead closer to each other, and the cutting means may be configured to cut the first lead and the second lead obliquely so that cutting surfaces of the leads are towards each other. The bending means are configured to bend the first lead and/or the second lead closer to each other in such a manner that the pitch of the leads becomes smaller than the pitch of the holes in the circuit board.

The bending means may comprise a spacer plate arrangeable between the first lead and the second lead, a first pushing arm for pushing the first lead against a first side of the spacer plate, and a second pushing arm for pushing the second lead against a second side of the spacer plate. The spacer plate and the pushing arms are moved with actuators, such as pneumatic or electric cylinders. The pitch of the leads after the radial electronic component has been processed is equal to the sum of the thickness of the spacer plate and the diameter of the lead. The spacer plate is preferably used in a case where the pitch of the leads is intended to be smaller than the pitch of the holes.

The bending means may be configured to bend the first lead and/or the second lead away from each other, and the cutting means may be configured to cut the first lead and the second lead obliquely so that cutting surfaces of the leads are away from each other. The bending means are configured to bend the first lead and/or the second lead away from each other in such a manner that that the pitch of the leads becomes larger than the pitch of the holes in the circuit board.

The bending means may comprise a first spacer arm and a second spacer arm that define a space into which the first lead and the second lead can be arranged, and a third pushing arm for pushing the first lead against the first spacer arm and a fourth pushing arm for pushing the second lead against the second spacer arm. The spacer arms and the pushing arms are moved with actuators, such as pneumatic or electric cylinders. The pitch of the leads after the radial electronic component has been processed is equal to the subtraction of the distance between the first and second spacer arms and the diameter of the lead. The spacer arms are preferably used in a case where the pitch of the leads is intended to be larger than the pitch of the holes.

The cutting means of the device may comprise a first cutting member and a second cutting member that are arranged movable with respect to each other. Preferably, the first and second cutting members are essentially planar and arranged movable in the same plane with each other. The first and second cutting members can be attached to an actuator that is configured to move the cutting members towards and away from each other. The first cutting member may comprise a projecting part for pressing leads of a radial electronic component against edges of a slot in the second cutting member. When the cutting members are moved towards each other the projecting part protrudes into the slot and as a result the edges of the slot cut the leads. Preferably, the projecting part and the slot have corresponding shapes so that the projecting part may slide into the slot in such a manner that the surfaces of the projecting part abut snugly against the corresponding surfaces of the slot. The cross-sectional shape of the projecting part and the slot is preferably a triangle allowing the leads to be cut obliquely in such a manner that the cutting surfaces of the leads have opposite orientations. Depending on the orientation of this triangle, the leads may be cut obliquely so that the cutting surfaces are towards or away from each other. The cutting members are preferably configured to cut the leads into the same length.

An unclaimed feeder for feeding radial electronic components comprises a device for processing a radial electronic component. The feeder can be used in an electronic component mounting device for feeding electronic components to a pick-up device that mounts the electronic components one at a time on a circuit board.

The exemplary embodiments of the invention presented in this text are not interpreted to pose limitations to the applicability of the appended claims. The verb "to comprise" is used in this text as an open limitation that does not exclude the existence of also unrecited features. The features recited in the dependent claims are mutually freely combinable unless otherwise explicitly stated.

BRIEF DESCRIPTION OF THE DRAWINGS

Fig. 1     illustrates a device for processing a radial electronic component according to a first example,

figs. 2A-2D     illustrate the bending of leads of a radial electronic component using the device of fig. 1,

figs. 3A-3B     illustrate the cutting of leads of a radial electronic component using the device of fig. 1,

fig. 4     illustrates a radial electronic component processed with the device of fig. 1,

fig. 5     illustrates a device for processing a radial electronic component according to a second example,

figs. 6A-6D     illustrate the bending of leads of a radial electronic component using the device of fig. 5,

figs. 7A-7B     illustrate the cutting of leads of a radial electronic component using the device of fig. 5, and

fig. 8     illustrates a radial electronic component processed with the device of fig. 5.

DETAILED DESCRIPTION OF THE DRAWINGS

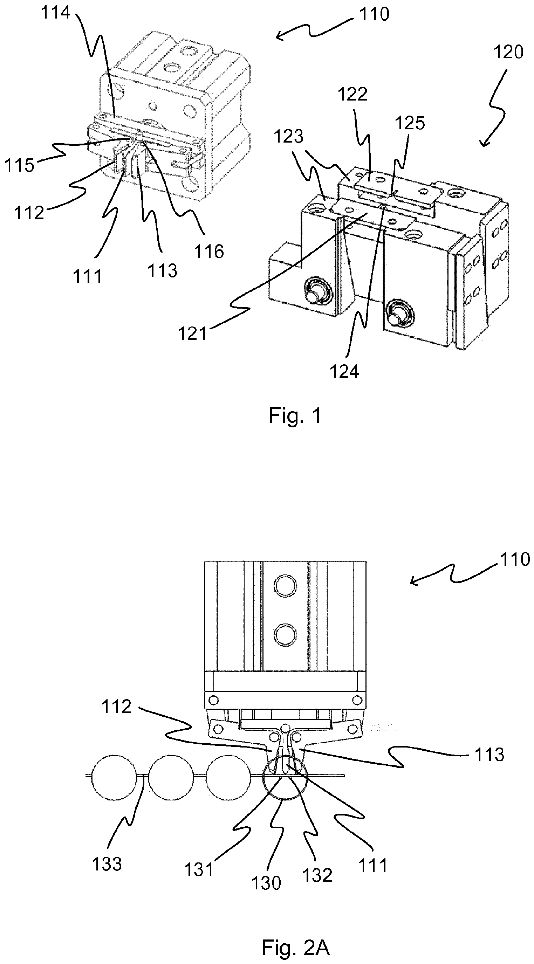

Fig. 1 illustrates a device for processing a radial electronic component according to a first example. The device comprises bending means 110 for bending leads of a radial electronic component (not shown in fig. 1) closer to each other. The bending means 110 is configured to bend the leads in such a manner that the pitch of the leads becomes smaller than the pitch of holes in a circuit board (not shown in fig. 1), into which holes the leads are to be inserted. The device also comprises cutting means 120 for cutting the leads of the radial electronic component obliquely so that the cutting surfaces of the leads are inclined towards each other. The bending means 110 and the cutting means 120 are arranged sequentially in such a manner that the leads are first bent with the bending means 110 and then cut with the cutting means 120. The radial electronic component to be processed is preferably conveyed with a component tape (not shown in fig. 1) from which the radial electronic component is detached with the cutting means 120.

The device of fig. 1 can be used in an electronic component mounting device to process leads of a radial electronic component before the radial electronic component is mounted on a circuit board. The radial electronic component that has been processed with the device of fig. 1 can be mounted to the circuit board by placing the ends of the leads into the holes in the circuit board and by pressing the component body towards the circuit board. When the leads protrude into the holes in the circuit board, the leads are pressed against the edges of the holes because the pitches of the leads and the holes differ from each other. The friction between the leads and the edges of the holes keeps the radial electronic component in place in the circuit board before and during the soldering of the leads to the circuit board. The bevelled ends of the leads facilitate the insertion of the leads into the holes.

The bending means 110 comprises a spacer plate 111 that is intended to be arranged between the leads of the radial electronic component. The bending means 110 also comprises pushing arms 112 and 113 for pushing the leads against different sides of the spacer plate 111. The pushing arms 112 and 113 are moved with an actuator 114 that rotates the pushing arms 112 and 113 around pivots 115 and 116. The pitch of the leads after the radial electronic component has been processed is equal to the sum of the thickness of the spacer plate 111 and the diameter of the lead.

The cutting means 120 comprises cutting members 121 and 122 that are attached to an actuator 123 that can move the cutting members 121 and 122 towards and away from each other. The cutting members 121 and 122 are essentially planar and arranged movable in the same plane relative to each other. The cutting member 121 comprises a projecting part 124 that may protrude into a slot 125 in the cutting member 122, when the cutting members 121 and 122 are moved towards each other. When the cutting members 121 and 122 are moved towards each other, the projecting part 124 can press the leads of the radial electronic component against edges of the slot 125, as a result of which the leads are cut obliquely. The projecting part 124 and the slot 125 have corresponding triangular cross-sectional shapes so that the projecting part 124 may slide into the slot 125 in such a manner that the surfaces of the projecting part 124 abut snugly against the corresponding surfaces of the slot 125. The triangular shape is oriented in such a manner that the cutting means 120 can cut the leads obliquely so that the cutting surfaces are towards each other.

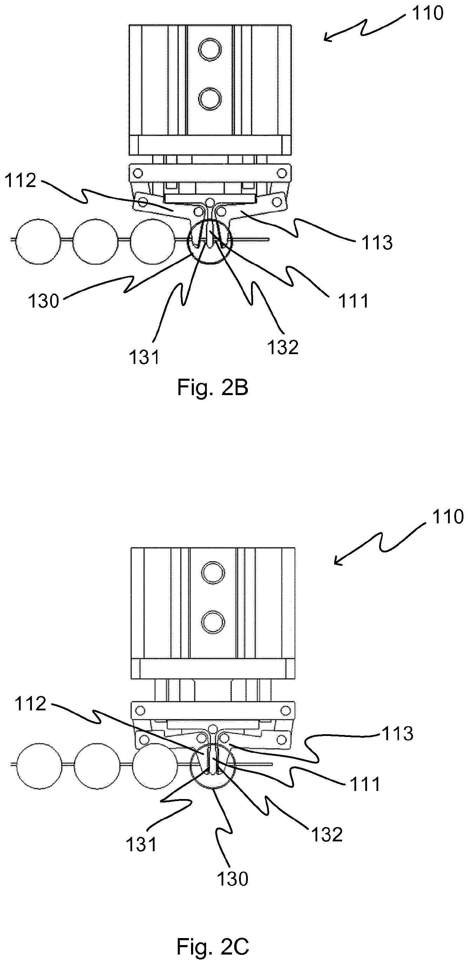

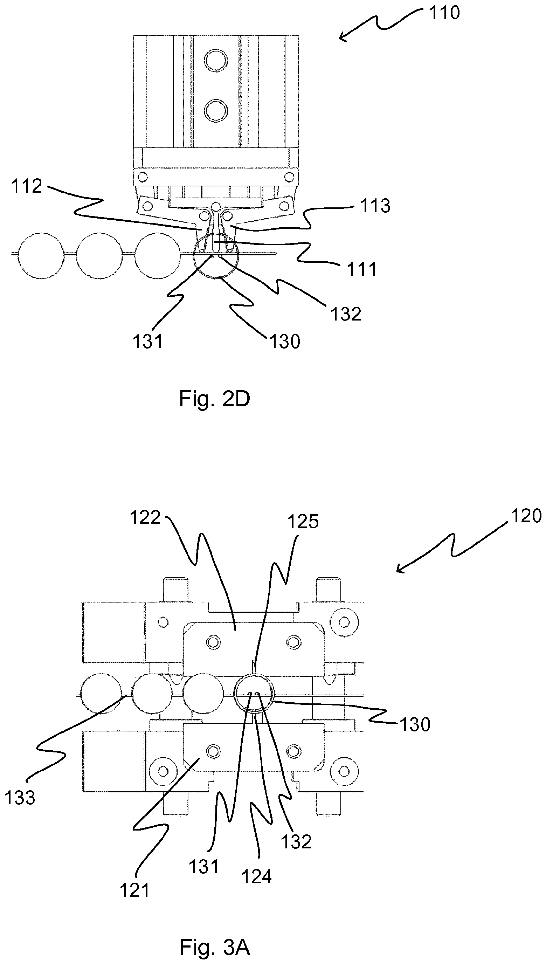

Figs. 2A-2D illustrate the bending of leads of a radial electronic component using the device of fig. 1. In figs. 2A-2D, a radial electronic component 130 is shown as transparent for illustrative purposes to provide a view of leads 131 and 132 as well as the spacer plate 111 and the pushing arms 112 and 113. In fig. 2A, there is shown a situation where the radial electronic component 130 attached to a component tape 133 has been moved to a position where it can be processed with the bending means 110. In fig. 2B, there is shown a situation where the bending means 110 has been moved forward so that the spacer plate 111 is between the leads 131 and 132. In fig. 2C, there is shown a situation where the leads 131 and 132 have been pushed against the spacer plate 111 with the pushing arms 112 and 113, whereby the leads 131 and 132 are bent closer to each other. In fig. 2D, there is shown a situation where the pushing arms 112 and 113 have been moved away from the spacer plate 111 and the bending means 110 has been moved backward so that the radial electronic component 130 can be moved forward to the cutting means 120.

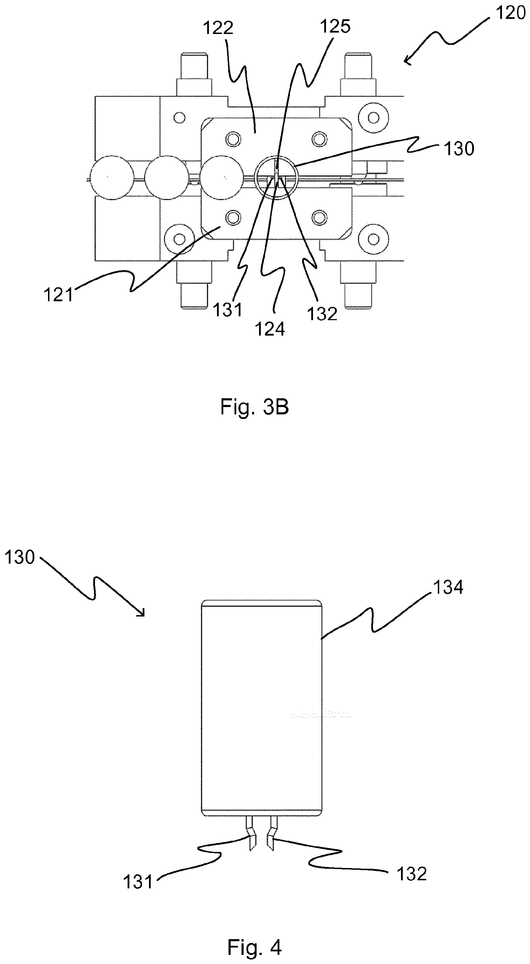

Figs. 3A-3B illustrate the cutting of leads of a radial electronic component using the device of fig. 1. In figs. 3A-3B, the radial electronic component 130 is shown as transparent for illustrative purposes to provide a view of the leads 131 and 132 as well as the projecting part 124 and the slot 125. In fig. 3A, there is shown a situation where the radial electronic component 130 attached to the component tape 133 has been moved from the bending means 110 to a position where it can be processed with the cutting means 120. The cutting members 121 and 122 are arranged in an open position and the leads 131 and 132 are arranged between the projecting part 124 and the slot 125. In fig. 3B, there is shown a situation where the cutting members 121 and 122 are arranged in a closed position whereby the projecting part 124 has protruded into the slot 125 and as a result the edges of the slot 125 have cut the leads 131 and 132 obliquely. The radial electronic component 130 is now ready to be picked up and placed on a circuit board.

Fig. 4 illustrates a radial electronic component processed with the device of fig. 1. As can be seen from fig. 4, the leads 131 and 132 are bent in such a manner that the distance between the leads 131 and 132 is larger at the end of a component body 134 than at the other end. The leads 131 and 132 are cut obliquely so that the cutting surfaces of the leads 131 and 132 are inclined towards each other and are at an angle of about 45 degrees with respective to the longitudinal axis of the lead 131, 132.

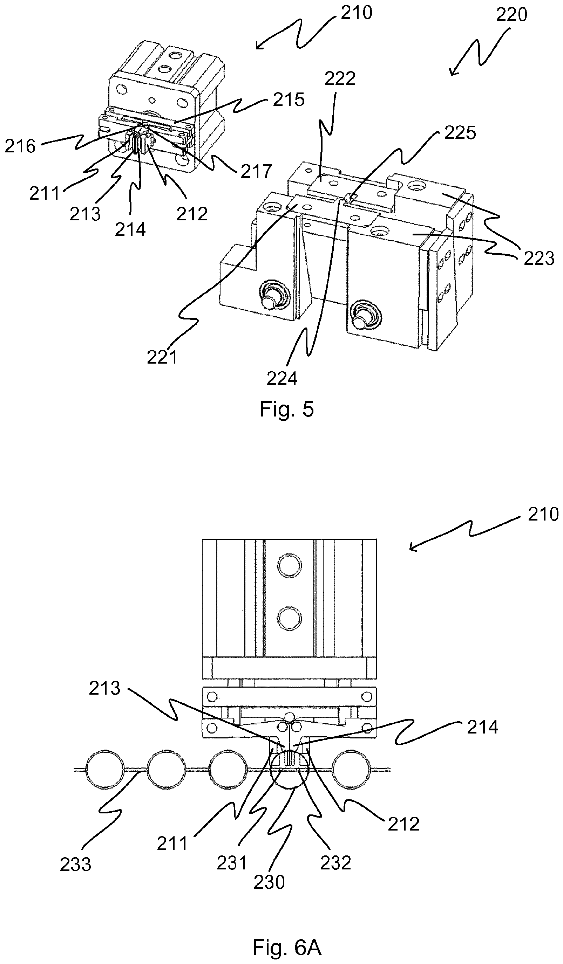

Fig. 5 illustrates a device, not forming a part of the invention, for processing a radial electronic component according to a second example. The device comprises bending means 210 for bending leads of a radial electronic component (not shown in fig. 5) away from each other. The bending means 210 is configured to bend the leads in such a manner that the pitch of the leads becomes larger than the pitch of holes in a circuit board (not shown in fig. 5), into which holes the leads are to be inserted. The device also comprises cutting means 220 for cutting the leads of the radial electronic component obliquely so that the cutting surfaces of the leads are inclined away from each other. The bending means 210 and the cutting means 220 are arranged sequentially in such a manner that the leads are first bent with the bending means 210 and then cut with the cutting means 220. The radial electronic component to be processed is preferably conveyed with a component tape (not shown in fig. 5) from which the radial electronic component is detached with the cutting means 220.

Like the device of fig. 1, the device of fig. 5 can be used in an electronic component mounting device to process leads of a radial electronic component before the radial electronic component is mounted on a circuit board.

The bending means 210 comprises spacer arms 211 and 212 that define a space into which the leads of the radial electronic component are intended to be arranged. The bending means 210 also comprises pushing arms 213 and 214 for pushing the leads against the spacer arms 211 and 212. The pushing arms 213 and 214 are moved with an actuator 215 that rotates the pushing arms 213 and 214 around pivots 216 and 217. The pitch of the leads after the radial electronic component has been processed is equal to the subtraction of the distance between the spacer arms 211 and 212 and the diameter of the lead.

The cutting means 220 comprises cutting members 221 and 222 that are attached to an actuator 223 that can move the cutting members 221 and 222 towards and away from each other. The cutting members 221 and 222 are essentially planar and arranged movable in the same plane relative to each other. The cutting member 221 comprises a projecting part 224 that may protrude into a slot 225 in the cutting member 222, when the cutting members 221 and 222 are moved towards each other. When the cutting members 221 and 222 are moved towards each other, the projecting part 224 can press the leads of the radial electronic component against edges of the slot 225, as a result of which the leads are cut obliquely. The projecting part 224 and the slot 225 have corresponding triangular cross-sectional shapes so that the projecting part 224 may slide into the slot 225 in such a manner that the surfaces of the projecting part 224 abut snugly against the corresponding surfaces of the slot 225. The triangular shape is oriented in such a manner that the cutting means 220 can cut the leads obliquely so that the cutting surfaces are away from each other.

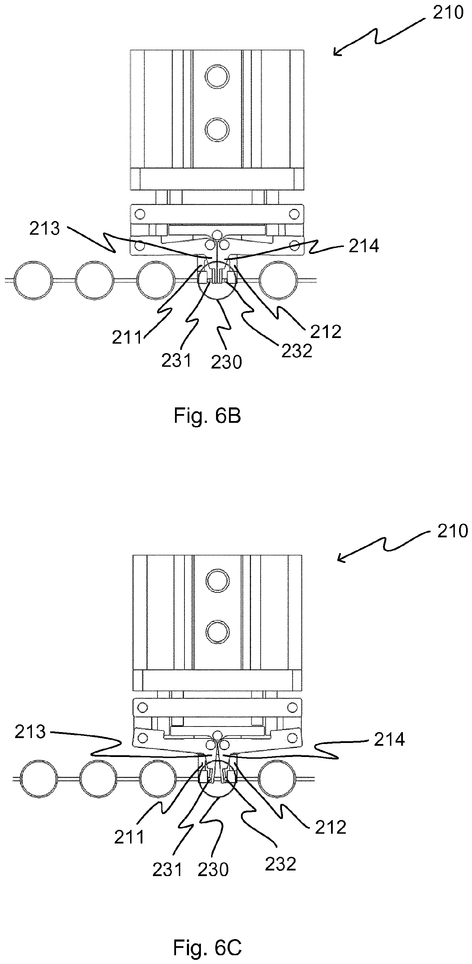

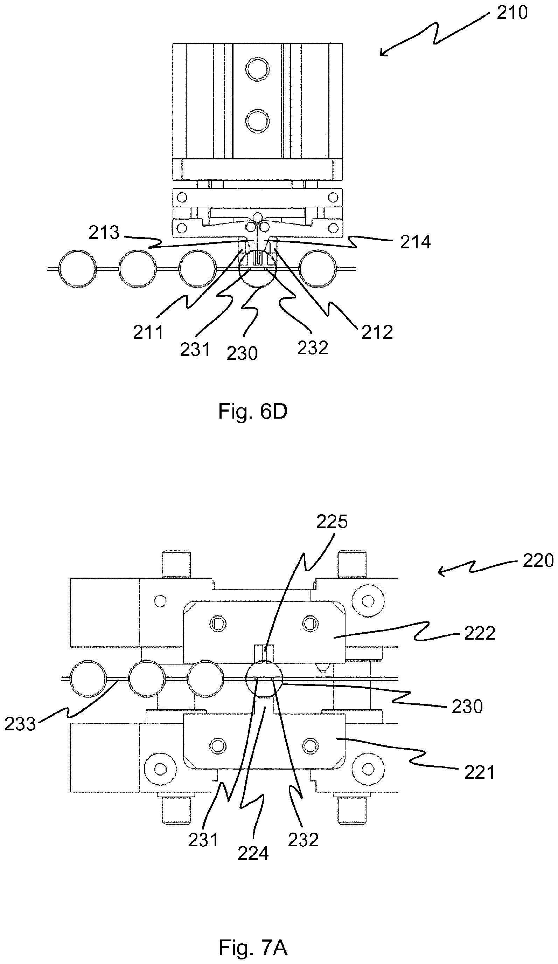

Figs. 6A-6D illustrate the bending of leads of a radial electronic component using the device of fig. 5. In figs. 6A-6D, a radial electronic component 230 is shown as transparent for illustrative purposes to provide a view of leads 231 and 232 as well as the spacer arms 211 and 212 and the pushing arms 213 and 214. In fig. 6A, there is shown a situation where the radial electronic component 230 attached to a component tape 233 has been moved to a position where it can be processed with the bending means 210. In fig. 6B, there is shown a situation where the bending means 210 has been moved forward so that the leads 231 and 232 are in a space defined by the spacer arms 211 and 212. In fig. 6C, there is shown a situation where the leads 231 and 232 have been pushed against the spacer arms 211 and 212 with the pushing arms 213 and 214, whereby the leads 231 and 232 are bent away from each other. In fig. 6D, there is shown a situation where the pushing arms 213 and 214 have been moved away from the spacer arms 211 and 212 and the bending means 210 has been moved backward so that the radial electronic component 230 can be moved forward to the cutting means 220.

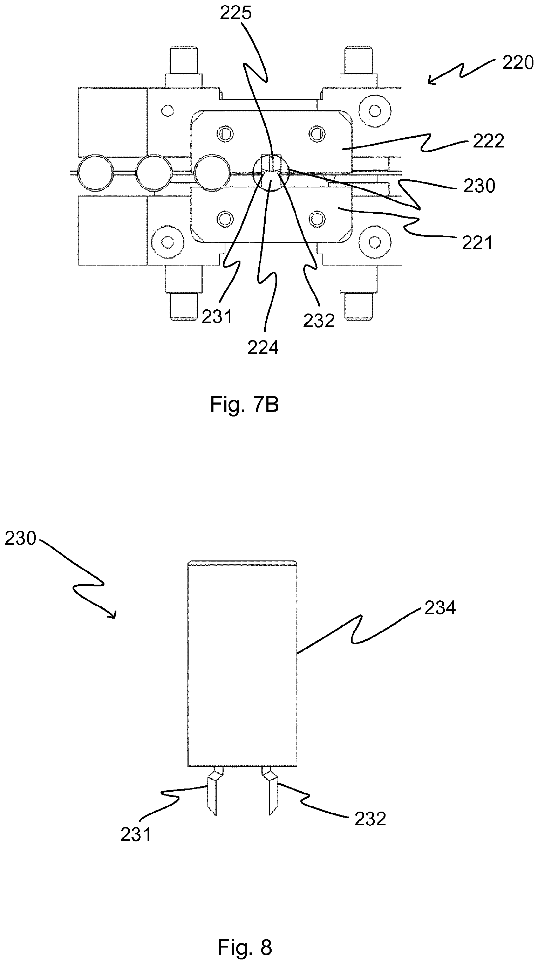

Figs. 7A-7B illustrate the cutting of leads of a radial electronic component using the device of fig. 5. In figs. 7A-7B, the radial electronic component 230 is shown as transparent for illustrative purposes to provide a view of the leads 231 and 232 as well as the projecting part 224 and the slot 225. In fig. 7A, there is shown a situation where the radial electronic component 230 attached to the component tape 233 has been moved from the bending means 210 to a position where it can be processed with the cutting means 220. The cutting members 221 and 222 are arranged in an open position and the leads 231 and 232 are arranged between the projecting part 224 and the slot 225. In fig. 7B, there is shown a situation where the cutting members 221 and 222 are arranged in a closed position whereby the projecting part 224 has protruded into the slot 225 and as a result the edges of the slot 225 have cut the leads 231 and 232 obliquely. The radial electronic component 230 is now ready to be picked up and placed on a circuit board.

Fig. 8 illustrates a radial electronic component processed with the device of fig. 5. As can be seen from fig. 8, the leads 231 and 232 are bent in such a manner that the distance between the leads 231 and 232 is smaller at the end of a component body 234 than at the other end. The leads 231 and 232 are cut obliquely so that the cutting surfaces of the leads 231 and 232 are inclined away from each other and are at an angle of about 45 degrees with respective to the longitudinal axis of the lead 231, 232.

## Claims

1. A method for processing a radial electronic component (130, 230), **characterised in that** the method comprises:

   - bending a first lead (131, 231) and/or a second lead (132, 232) of the radial electronic component (130, 230) so that the pitch of the leads (131, 132, 231, 232), which means a distance between the centres of the ends of the leads (131, 132, 231, 232), is different from the pitch of holes in a circuit board, into which holes the leads (131, 132, 231, 232) are to be inserted,
   - cutting the first lead (131, 231) and the second lead (132, 232) obliquely, and
   - inserting the first lead (131, 231) and the second lead (132, 232) into the holes in the circuit board,

   wherein:

   - the first lead (131) and/or the second lead (132) is bent so that the pitch of the leads (131, 132) is smaller than the pitch of the holes, and the first lead (131) and the second lead (132) are cut obliquely so that cutting surfaces of the leads (131, 132) are towards each other, the mathematical relationship between the pitches of the leads and the holes and the diameters of the leads and the holes being expressed by the following equation:

$$p_H - d_H - d_L < p_L < p_H,$$

   wherein $p_H$ denotes the pitch of the holes, $p_L$ denotes the pitch of the leads, $d_H$ denotes the diameter of the hole and $d_L$ denotes the diameter of the lead, or
   - the first lead (231) and/or the second lead (232) is bent so that the pitch of the leads (231, 232) is larger than the pitch of the holes, and the first lead (231) and the second lead (232) are cut obliquely so that the cutting surfaces of the leads (231, 232) are away from each other, the mathematical relationship between the pitches of the leads and the holes and the diameters of the leads and the holes being expressed by the following equation:

$$p_H < p_L < p_H + d_H + d_L,$$

wherein $p_H$ denotes the pitch of the holes, $p_L$ denotes the pitch of the leads, $d_H$ denotes the diameter of the hole and $d_L$ denotes the diameter of the lead.

2. The method according to claim 1, **characterised in that** the first lead (131, 231) and/or the second lead (132, 232) is bent so that the pitch of the leads (131, 132, 231, 232) differs from the pitch of the holes by at least 0.1 mm.

3. The method according to claim 1 or 2, **characterised in that** the first lead (131, 231) and the second lead (132, 232) are cut at an angle of 20 to 70 degrees with respective to the longitudinal axis of the lead (131, 132, 231, 232).

4. The method according to claim 1, **characterised in that** the step of bending a first lead (131) and/or a second lead (132) of the radial electronic component (130) comprises:

   - arranging a spacer plate (111) having opposite first and second sides between the first lead (131) and the second lead (132), and
   - pushing the first lead (131) against the first side and the second lead (132) against the second side of the spacer plate (111).

5. The method according to claim 1, **characterised in that** the step of bending a first lead (231) and/or a second lead (232) of the radial electronic component (230) comprises:

   - arranging the first lead (231) and the second lead (232) in a space between a first spacer arm (211) and a second spacer arm (212), and
   - pushing the first lead (231) against the first spacer arm (211) and the second lead (232) against the second spacer arm (212).

**Patentansprüche**

1. Verfahren zum Bearbeiten eines radialen elektronischen Bauteils (130, 230), **dadurch gekennzeichnet, dass** das Verfahren Folgendes umfasst:

   - Biegen einer ersten Zuleitung (131, 231) und/oder einer zweiten Zuleitung (132, 232) des radialen elektronischen Bauteils (130, 230), so dass sich der Abstand der Zuleitungen (131, 132, 231, 232), was einen Abstand zwischen den Mitten der Enden der Zuleitungen (131, 132, 231, 232) bedeutet, von dem Abstand von Löchern in einer Leiterplatte unterscheidet, in die die Zuleitungen (131, 132, 231, 232) einzuführen sind,
   - schräges Schneiden der ersten Zuleitung (131, 231) und der zweiten Zuleitung (132, 232), und
   - Einführen der ersten Zuleitung (131, 231) und der zweiten Zuleitung (132, 232) in die Löcher in der Leiterplatte,

   wobei:

   - die erste Zuleitung (131) und/oder die zweite Zuleitung (132) so gebogen ist, dass der Abstand der Zuleitungen (131, 132) kleiner ist als der Abstand der Löcher, und die erste Leitung (131) und die zweite Leitung (132) schräg geschnitten sind, so dass die Schneidflächen der Zuleitungen (131, 132) zueinander gerichtet sind, wobei die mathematische Beziehung zwischen den Abständen der Zuleitungen und der Löcher und den Durchmessern der Zuleitungen und der Löcher durch die folgende Gleichung ausgedrückt wird:

$$p_H - d_H - d_L < p_L < p_H,$$

   wobei $p_H$ den Abstand der Löcher bezeichnet, $p_L$ den Abstand der Zuleitungen bezeichnet, $d_H$ den Durchmesser des Lochs bezeichnet und $d_L$ den Durchmesser der Zuleitung bezeichnet, oder
   - die erste Zuleitung (231) und/oder die zweite Zuleitung (232) gebogen ist, so dass der Abstand der Zuleitungen (231, 232) größer ist als der Abstand der Löcher, und die erste Zuleitung (231) und die zweite Zuleitung (232) schräg geschnitten sind, so dass die Schneidflächen der Zuleitungen (231, 232) voneinander entfernt sind, wobei die mathematische Beziehung zwischen den Abständen der Leitungen und der Löcher und den Durchmessern der Leitungen und der Löcher durch die folgende Gleichung ausgedrückt wird:

$$p_H < p_L < p_H + d_H + d_L,$$

   wobei $p_H$ den Abstand der Löcher bezeichnet, $p_L$ den Abstand der Zuleitungen bezeichnet, $d_H$ den Durchmesser des Lochs bezeichnet und $d_L$ den Durchmesser der Zuleitung bezeichnet.

2. Verfahren nach Anspruch 1, **dadurch gekennzeichnet, dass** die erste Zuleitung (131, 231) und/oder die zweite Zuleitung (132, 232) gebogen wird, so dass der Abstand der Zuleitungen (131, 132, 231, 232) sich von dem Abstand der Löcher um mindestens 0,1 mm unterscheidet.

**3.** Verfahren nach Anspruch 1 oder 2, **dadurch gekennzeichnet, dass** die erste Zuleitung (131, 231) und die zweite d (132, 232) in einem Winkel von 20 bis 70 Grad bezüglich der Längsachse der Zuleitung (131, 132, 231, 232) geschnitten sind.

**4.** Verfahren nach Anspruch 1, **dadurch gekennzeichnet, dass** der Schritt des Biegens einer ersten Zuleitung (131) und/oder einer zweiten Zuleitung (132) des radialen elektronischen Bauteils (130) Folgendes umfasst

- Anordnen einer Abstandsplatte (111) mit gegenüberliegenden ersten und zweiten Seiten zwischen der ersten Zuleitung (131) und der zweiten Zuleitung (132), und
- Schieben der ersten Zuleitung (131) gegen die erste Seite und der zweiten Zuleitung (132) gegen die zweite Seite der Abstandsplatte (111).

**5.** Verfahren nach Anspruch 1, **dadurch gekennzeichnet, dass** der Schritt des Biegens einer ersten Zuleitung (231) und/oder einer zweiten Zuleitung (232) des radialen elektronischen Bauteils (230) Folgendes umfasst

- Anordnen der ersten Zuleitung (231) und der zweiten Zuleitung (232) in einem Zwischenraum zwischen einem ersten Abstandsarm (211) und einem zweiten Abstandsarm (212), und
- Schieben der ersten Zuleitung (231) gegen den ersten Abstandsarm (211) und der zweiten Zuleitung (232) gegen den zweiten Abstandsarm (212).

**Revendications**

**1.** Procédé de traitement d'un composant électronique radial (130, 230), **caractérisé en ce que** le procédé comprend :

- le pliage d'un premier conducteur (131, 231) et/ou d'un second conducteur (132, 232) du composant électronique radial (130, 230) de sorte que le pas des conducteurs (131, 132, 231, 232), ce qui signifie une distance entre les centres des extrémités des conducteurs (131, 132, 231, 232), est différent du pas de trous dans une carte de circuit imprimé, dans lesquels trous les conducteurs (131, 132, 231, 232) doivent être insérés,
- la découpe du premier conducteur (131, 231) et du second conducteur (132, 232) obliquement, et
- l'insertion du premier conducteur (131, 231) et du second conducteur (132, 232) dans les trous dans la carte de circuit imprimé,

dans lequel :

- le premier conducteur (131) et/ou le second conducteur (132) sont pliés de sorte que le pas des conducteurs (131, 132) est inférieur au pas des trous, et le premier conducteur (131) et le second conducteur (132) sont découpés obliquement de sorte que des surfaces de découpe des conducteurs (131, 132) sont l'une vers l'autre, la relation mathématique entre les pas des conducteurs et des trous et les diamètres des conducteurs et des trous étant exprimée par l'équation suivante :

$$p_H - d_H - d_L < p_L < p_H,$$

où $p_H$ désigne le pas des trous, $p_L$ désigne le pas des conducteurs, $d_H$ désigne le diamètre du trou et $d_L$ désigne le diamètre du conducteur, ou
- le premier conducteur (231) et/ou le second conducteur (232) sont pliés de sorte que le pas des conducteurs (231, 232) est supérieur au pas des trous, et le premier conducteur (231) et le second conducteur (232) sont découpés obliquement de sorte que les surfaces de découpe des conducteurs (231, 232) sont à distance l'une de l'autre, la relation mathématique entre les pas des conducteurs et des trous et les diamètres des conducteurs et des trous étant exprimée par l'équation suivante :

$$p_H < p_L < p_H + d_H + d_L,$$

où $p_H$ désigne le pas des trous, $p_L$ désigne le pas des conducteurs, $d_H$ désigne le diamètre du trou et $d_L$ désigne le diamètre du conducteur.

**2.** Procédé selon la revendication 1, **caractérisé en ce que** le premier conducteur (131, 231) et/ou le second conducteur (132, 232) est plié de sorte que le pas des conducteurs (131, 132, 231, 232) diffère du pas des trous d'au moins 0,1 mm.

**3.** Procédé selon la revendication 1 ou 2, **caractérisé en ce que** le premier conducteur (131, 231) et le second conducteur (132, 232) sont découpés selon un angle de 20 à 70 degrés par rapport à l'axe longitudinal du conducteur (131, 132, 231, 232).

**4.** Procédé selon la revendication 1, **caractérisé en ce que** l'étape de pliage d'un premier conducteur (131) et/ou d'un second conducteur (132) du composant électronique radial (130) comprend :

- l'agencement d'une plaque d'espacement (111) ayant des premier et second côtés opposés entre le premier conducteur (131) et le second conducteur (132), et
- la poussée du premier conducteur (131) contre le premier côté et du second conducteur (132) contre le second côté de la plaque d'espacement (111).

5.  Procédé selon la revendication 1, **caractérisé en ce que** l'étape de pliage d'un premier conducteur (231) et/ou d'un second conducteur (232) du composant électronique radial (230) comprend :

- l'agencement du premier conducteur (231) et du second conducteur (232) dans un espace entre un premier bras d'espacement (211) et un second bras d'espacement (212), et
- la poussée du premier conducteur (231) contre le premier bras d'espacement (211) et du second conducteur (232) contre le second bras d'espacement (212) .

Fig. 1

Fig. 2A

110

112

113

130

131    132

111

Fig. 2B

110

112

113

111

131

132

130

Fig. 2C

Fig. 2D

Fig. 3A

Fig. 3B

Fig. 4

Fig. 5

Fig. 6A

Fig. 6B

Fig. 6C

Fig. 6D

Fig. 7A

225

220

222

230

221

231  232

224

Fig. 7B

230

234

232

231

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013025923 A
- US 2003038160 A